(19) Europäisches Patentamt
European Patent Office
Office européen des brevets

(11) EP 2 866 274 A1

(12) **EUROPEAN PATENT APPLICATION**
published in accordance with Art. 153(4) EPC

(43) Date of publication:
**29.04.2015 Bulletin 2015/18**

(21) Application number: **13809087.3**

(22) Date of filing: **27.05.2013**

(51) Int Cl.:
***H01L 51/42** (2006.01)* ***H01L 31/10** (2006.01)*

(86) International application number:
**PCT/JP2013/064604**

(87) International publication number:
**WO 2014/002664 (03.01.2014 Gazette 2014/01)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **26.06.2012 JP 2012142712**

(71) Applicant: **Toray Industries, Inc.**
**Tokyo 103-8666 (JP)**

(72) Inventors:
- **SHIMOMURA, Satoru**
**Otsu-shi**
**Shiga 520-8558 (JP)**
- **YAMAMOTO, Shuhei**
**Otsu-shi**
**Shiga 520-8558 (JP)**
- **KITAZAWA, Daisuke**
**Otsu-shi**
**Shiga 520-8558 (JP)**

(74) Representative: **Webster, Jeremy Mark et al**
**Mewburn Ellis LLP**
**33 Gutter Lane**
**London EC2V 8AS (GB)**

# (54) PHOTOVOLTAIC ELEMENT

(57) In order to provide a photovoltaic element having a high photoelectric conversion efficiency, this photovoltaic element comprises at least a positive electrode, a photoelectric conversion layer, an electron extraction layer, and a negative electrode, in that order, and is characterized in that the electron extraction layer contains at least one compound of the compound group represented by a particular general formula.

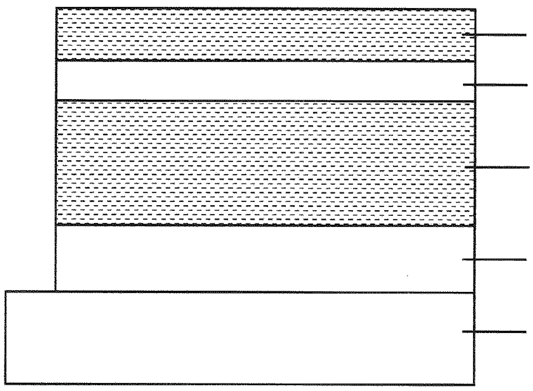


Figure 1

EP 2 866 274 A1

## Description

### TECHNICAL FIELD

The present invention relates to a photovoltaic element.

### BACKGROUND ART

Solar cells that provide an environment-friendly electric energy source have been drawn public attentions as an effective energy source that can solve energy problems that have currently become more and more serious. At present, as a semiconductor material for use in photovoltaic elements for solar cells, inorganic substances, such as single crystal silicon, polycrystal silicon, amorphous silicon, and a compound semiconductor, have been used. However, since the solar cell to be produced by using inorganic semiconductors requires high costs in comparison with other power generation systems such as thermal power generation and nucleic power generation, it has not been widely used for general household purposes. The main reason for the high costs lies in that a process for manufacturing a semiconductor thin-film under vacuum at high temperatures is required. For this reason, organic solar cells have been examined in which, as a semiconductor material that can desirably simplify the manufacturing process, an organic semiconductor and an organic colorant, such as a conjugated polymer and an organic crystal, are utilized. In such organic solar cells, the manufacturing process can be simplyfied since the semiconductor material can be prepared by an application method.

However, since conventional organic solar cells using the conjugated polymer or the like is low in their photoelectric conversion efficiency in comparison with conventional solar cells using inorganic semiconductors, these solar cells have not been put into practical use. In order to put the organic solar cell into practical use, it is essential to develop a method capable of realizing higher photoelectric conversion efficiency.

An example of a method of improving the photoelectric conversion efficiency of the organic solar cell includes a method of disposing an electron extraction layer between a photoelectric conversion layer made of a stacked film of copper phthalocyanine and fullerene and a silver cathode. By this method, the degradation of the photoelectric conversion layer is suppressed through vapor deposition of the silver cathode, and thereby, conversion efficiency is improved. Further, it is investigated to use a material having ionic groups introduced for the electron extraction layer of the organic solar cell.

For example, it is disclosed that the conversion efficiency is improved by using, as the electron extraction layer of the organic solar cell, a substituted fluorene polymer (Non-patent Document 1) having ammonium acetate salt introduced as the ionic group.

Also, a charge injection material for organic devices, which contains an aromatic compound having a coordinating functional group being an ionic group, is disclosed, and it is suggested that the charge injection material is applied to the electron extraction layer of the organic solar cell (see Patent Document 1, Non-patent Document 2).

### PRIOR ART DOCUMENTS

### PATENT DOCUMENTS

Patent Document 1: Japanese Patent Laid-open Publication No. 2005-353401 (claims 1, 8)

### NON-PATENT DOCUMENT

Non-patent Document 1: "Advanced Materials", pp. 4636-4643, Volume 23, 2011
Non-patent Document 2: "Advanced Functional Materials", pp. 4338-4341, Volume 21, 2011

### SUMMARY OF THE INVENTION

### PROBLEMS TO BE SOLVED BY THE INVENTION

However, in accordance with findings of the present inventors, the effect of improving the photoelectric conversion efficiency by conventional insertion of the electron extraction layer is not yet adequate in looking ahead to its practical use. The reason for this is that for example, in the case of fluorene polymer as described in Non-patent Document

1, since the polymer is characterized by a long conjugation length, the polymer absorbs light in a visible region in stacking the polymer, resulting in a reduction of element characteristics, and therefore a film thickness to which the polymer is adapted is limited. It is difficult to uniformly apply a thin electron extraction layer, and the resulting layer tends to have large surface roughness and cannot adequately function as an electron extraction layer.

Also, the present inventors thought that when the aromatic compound as described in Patent Document 1 or No-patent Document 2 is used, the conjugation length of the aromatic compound is not long in the case of a single molecule, but the aromatic compound might have a new optical absorption region resulting from a intermolecular interaction due to stacking in the case of stacking the aromatic compound.

Thus, it is an object of the present invention to provide a photovoltaic element which has higher photoelectric conversion efficiency by using an organic material not having optical absorption in a visible region for the electron extraction layer.

## SOLUTIONS TO THE PROBLEMS

Taking the above-mentioned problem into consideration, the present inventors noted an alkyl compound not containing an aromatic ring or a conjugated double bond. Then, with earnest effort and struggle, the present inventors could find that by using an alkyl compound prepared by introducing a specific ionic group for the electron extraction layer, a photovoltaic element having excellent photoelectric conversion efficiency can be attained.

That is, the present invention pertains to a photovoltaic element comprising at least an anode, a photoelectric conversion layer, an electron extraction layer and a cathode in this order, wherein the electron extraction layer contains a compound represented by the following general formula (1) :

[Chem. 1]

$$R — X^- M^+ \qquad (1)$$

wherein R is selected from among hydrogen, and alkyl group which may have a substituent, $X^-$ is selected from among -COO-, $-SO_3^-$, $-PO_4H^-$, $-PO_4^{2-}$, $-O-SO_3^-$, and M is selected from among alkali metals, and alkaline-earth metals.

## EFFECTS OF THE INVENTION

In accordance with the present invention, it is possible to provide a photovoltaic element having high photoelectric conversion efficiency.

## BRIEF DESCRIPTION OF THE DRAWINGS

Fig. 1 is a sectional view showing one aspect of a photovoltaic element in accordance with the present invention.

## EMBODIMENTS OF THE INVENTION

A photovoltaic element of the present invention is a photovoltaic element comprising at least an anode, a photoelectric conversion layer, an electron extraction layer and a cathode in this order, wherein the electron extraction layer contains a compound represented by the following general formula (1) :

[Chem. 2]

$$R — X^- M^+ \qquad (1)$$

wherein R is selected from among hydrogen, and alkyl group which may have a substituent, $X^-$ is selected from among -COO-, $-SO_3^-$, $-PO_4H^-$, $-PO_4^{2-}$, $-O-SO_3^-$, and M is selected from among alkali metals, alkaline-earth metals, and ammonium ion.

The alkyl group which may have a substituent represent saturated aliphatic hydrocarbon groups such as a methyl group, an ethyl group, a propyl group and a butyl group. The alkyl group which may have a substituent may also be saturated aliphatic hydrocarbon polymers such as polyethylene and polypropylene.

When a substituent is present, examples thereof include the above-mentioned alkyl group, alkoxy group, halogen atoms, hydroxyl group, cyano group, amino group, carboxyl group, carbonyl group, acetyl group, sulfonyl group, silyl group, boryl group, nitrile group, and groups formed by combining these groups. When a substituent is present, the substituent does not include an aryl group and a conjugated double bond-based orgnic groups. Examples of the above-mentioned alkoxy group include aliphatic hydrocarbon groups, which is combined through an ether bond, such as a methoxy group, an ethoxy group, a propoxy group and a buthoxy group.

A specific substituent represented by R will be exemplified. However, the substituents to be exemplified are a part of the substituents included in the present invention, and the present invention is not limited to these. In addition, in the substituent exemplified below, a single line extending in a left horizontal direction indicates a bond position of the substituent. Further, a description of a methyl group at a terminal may be omitted.

[Chem. 3]

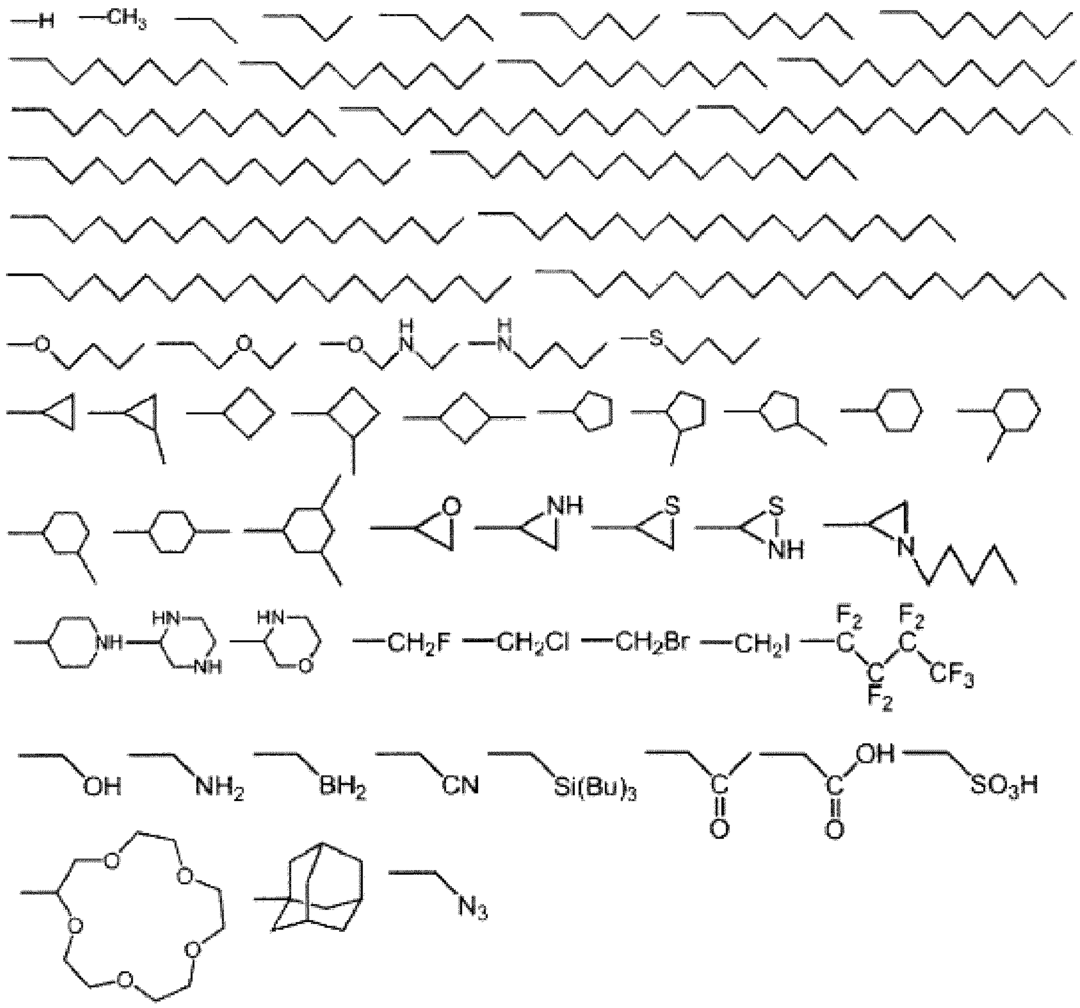

X- is selected from among -COO-, $-SO_3^-$, $-PO_4H^-$, $-PO_4^{2-}$, and $-O-SO_3^-$. In order to realize higher electron extraction efficiency, $-SO_3$- and -COO- are preferably used. More preferably, -COO- is used.

M is selected from among alkali metals, alkaline-earth metals, and ammonium ion. The alkali metal is any of Li, Na, K, Rb, Cs and Fr. The alkaline-earth metal is any of Be, Mg, Ca, Sr, Ba and Ra. More preferably, Na is used.

Next, a specific compound represented by the above-mentioned general formula (1) will be exemplified. However, the compounds to be exemplified are a part of the compounds included in the present invention, and the present invention is not limited to these. Examples of the compounds represented by the general formula (1) include compounds having the following structures.

[Chem. 4]

$H-CO_2Na$

$H_3C-CO_2Na$

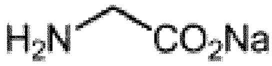

$H_3C(H_2C)_{10}-CO_2Na$

$H_3C(H_2C)_{12}-CO_2Na$

$H_3C(H_2C)_{14}-CO_2Na$

$H_3C(H_2C)_{16}-CO_2Na$

$F_3C(F_2C)_6-CO_2NH_4$

$H_3C(H_2C)_{11}-SO_3Na$

$H_3C(H_2C)_{12}-SO_3Na$

$H_3C(H_2C)_{13}-SO_3Na$

$H_3C(H_2C)_{14}-SO_3Na$

$H_3C(H_2C)_{15}-SO_3Na$

$H_3C(H_2C)_{17}-SO_3Na$

$F_3C(F_2C)_7-SO_3NH_4$

$F_3C(F_2C)_7-SO_3Li$

$F_3C(F_2C)_7-SO_3Li$

$H_3C(H_2C)_{11}-O-SO_3Na$

$H_3C(H_2C)_{15}-O-SO_3Na$

$H_3C(H_2C)_{17}-O-SO_3Na$

$H_3C(H_2C)_{11}-O-PO_3Na_2$

$H_3C(H_2C)_{11}-O-PO_3HNa$

$H_3C(H_2C)_{11}-O-PO_3Ca$

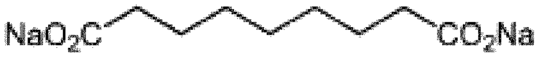

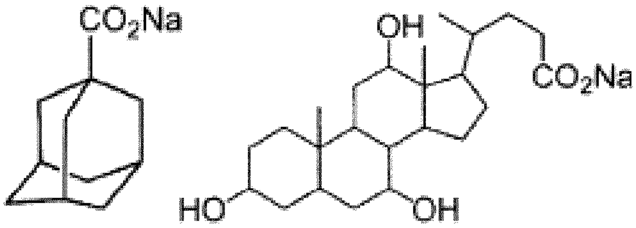

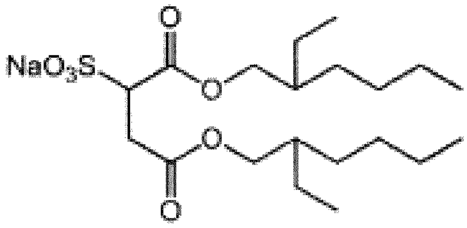

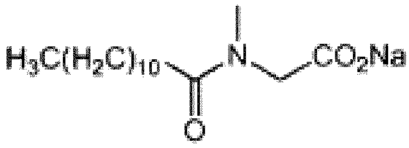

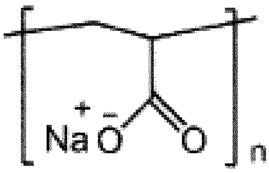

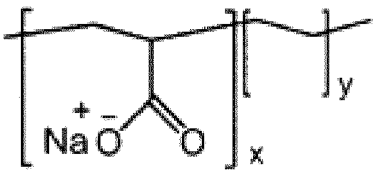

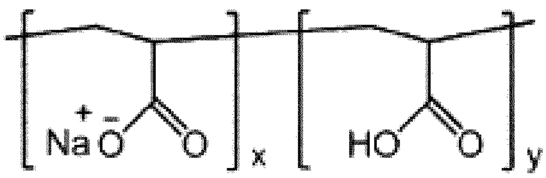

Next, the photovoltaic element of the present invention will be described. Fig. 1 is a sectional view showing one aspect of a photovoltaic element in accordance with the present invention. The photovoltaic element has an anode 2, a photoelectric conversion layer 3, an electron extraction layer 4 containing a compound group represented by the above-mentioned general formula (1), and a cathode 5 in this order on a substrate 1.

As the substrate 1, a substrate, on which an electrode and a photoelectric conversion layer can be stacked, may be selected to be used. As the substrate 1, for example, it is possible to use a film or a plate made from an inorganic material such as non-alkali glass and quartz glass, or an organic material such as polyester, polycarbonate, polyolefin, polyamide, polyimide, polyphenylene sulfide, polyparaxylene, an epoxy resin and a fluorine-based resin by using any method. Further, in the case where light is made incident on the substrate 1 side, the light transmittance of the substrate is preferably 60 to 100%. Herein, the light transmittance is a value obtained by the following expression:

$$[\text{Transmitted light intensity } (W/m^2)/\text{Incident light intensity } (W/m^2)] \times 100\ (\%)$$

The anode or the cathode of the photovoltaic element of the present invention has a light-transmitting property. At least either the anode or the cathode may have a light-transmitting property, and both of them may have a light-transmitting property. Herein, the term "having a light-transmitting property" refers to a level at which an electromotive force is generated by incident light arrival at the photoelectric conversion layer. That is, when the electrode has a light transmittance more than 0%, it is assumed that the electrode has a light-transmitting property. The electrode having the light-transmitting property preferably has a light transmittance of 60-100% in a region of all wavelengths of 400 nm or more and 900 nm or less. Further, the thickness of the electrode having the light-transmitting property may be one at which sufficient conducting properties can be achieved, and the thickness is preferably 20 to 300 nm, differing depending on an electrode material. In addition, the electrode not having the light-transmitting property is enough if having conducting properties, and the thickness thereof is not particularly limited.

As the electrode material, it is preferred to use a conductive material having a high work function for the anode and a conductive material having a low work function for the cathode.

As the conductive material having a high work function, metals such as gold, platinum, chromium and nickel, oxides of metals such as indium and tin, having transparency, or composite metal oxides thereof (indium tin oxide (ITO) and indium zinc oxide (IZO), etc.), and conductive polymers are preferably used. Further, the anode more preferably has a hole extraction layer. It is possible to form an interface state suitable for extracting a carrier by the hole extraction layer. Moreover, the hole extraction layer has the effect of preventing short circuit between electrodes. As a material used for forming the hole extraction layer, a conductive polymer such as a polythiophene polymer, a poly(p-phenylenevinylene) polymer and a polyfluorene polymer, which contain a dopant, and a metal oxide such as molybdenum oxide are preferably used. In addition, the polythiophene polymer, the poly(p-phenylenevinylene) polymer, and the polyfluorene polymer refer to polymers having a thiophene skeleton, a p-phenylenevinylene skeleton and a fluorene skeleton, respectively, in a main chain. Among them, a mixture of molybdenum oxide or the polythiophene polymer such as polyethylene dioxythiophene (PEDOT) containing a dopant, particularly PEDOT, and polystyrene sulfonate (PSS) is more preferred. Further, the hole extraction layer may be formed by stacking a plurality of these materials, and the materials to be stacked may be different.

As the conductive material having a low work function, alkali metals such as lithium, alkaline-earth metals such as magnesium and calcium, tin, silver and aluminum are preferably used. Moreover, electrodes composed of alloys made from the above-mentioned metals or laminates of the above-mentioned metals are also preferably used. The cathode may contain a metal fluoride such as lithium fluoride or cesium fluoride.

Next, the photoelectric conversion layer in the photovoltaic element of the present invention will be described. The photoelectric conversion layer is supported by sandwiching it between the anode and the cathode and contains at least (A) an electron donating organic semiconductor and (B) an electron accepting organic semiconductor respectively described later. Examples of a structure of the photoelectric conversion layer include a layer structure made of a mixture of the electron donating organic semiconductor and the electron accepting organic semiconductor; a structure of stacking a layer made of the electron donating organic semiconductor on a layer made of the electron accepting organic semiconductor; and a stacked structure of the layer made of the electron donating organic semiconductor, the layer made of the electron accepting organic semiconductor and the layer made of the mixture of these two materials and interposed between these two layers. The photoelectric conversion layer may contain two or more kinds of the electron donating organic semiconductor or the electron accepting organic semiconductor. The electron donating organic semiconductor and the electron accepting organic semiconductor in the present invention preferably form a mixed layer together. The content rates of the electron donating organic semiconductor and the electron accepting organic semiconductor in the photoelectric conversion layer are not particularly limited; however, the rate by weight of the electron accepting organic semiconductor is preferably set in a range from 1 to 99 : 99 to 1, more preferably from 10 to 90 : 90 to 10, and moreover preferably from 20 to 60 : 80 to 40. The photoelectric conversion layer may have a thickness enough for generating a photovoltaic power based on optical absorption of (A) the electron donating organic semiconductor and (B) the electron accepting organic semiconductor. The photoelectric conversion layer preferably has the thickness of 10 to 1000 nm,

more preferably 50 to 500 nm, differing depending on a photoelectric conversion layer material. The photoelectric conversion layer in the present invention may contain other components such as a surfactant, a binder resin or a filler within a range which does not impair the object of the present invention.

(A) The electron donating organic semiconductor is not particularly limited as long as it is an organic material exhibiting p-type semiconductor properties. Examples of the electron donating organic semiconductor include conjugated polymers, such as a polythiophene polymer, a 2,1,3-benzothiadiazole-thiophene copolymer, a quinoxaline-thiophene copolmer, a thiophene-benzothiophene copolmer, a poly(p-phenylenevinylene) polymer, a poly(p-phenylene) polymer, a polyfluorene polymer, a polypyrrole polymer, a polyaniline polymer, a polyacetylene polymer, and a poly(thienylene vinylene) polymer; and low-molecular weight organic compounds including phthalocyanine derivatives, such as $H_2$ phthalocyanine ($H_2Pc$), copper phthalocyanine (CuPc) and zinc phthalocyanine (ZnPc), porphyrin derivatives, triaryl amine derivatives, such as N,N'-diphenyl-N,N'-di(3-methylphenyl)-4,4'-diphenyl-1,1'-di amine (TPD) and N,N'-dinaphtyl-N,N'-diphenyl-4,4'-diphenyl-1,1'-diamine (NPD), carbazole derivatives, such as 4,4'-di(carbazole-9-yl)biphenyl (CBP), and oligothiophene derivatives (terthiophene, quaterthiophene, sexithiophene, octithiophene, etc.). Two or more kinds of these may be used.

Polythiophene polymer refers to a conjugated polymer having a thiophene skeleton in a main chain, and also includes a conjugated polymer having a side chain. Specific examples thereof include poly(3-alkylthiophene) such as poly(3-methylthiophene), poly(3-butylthiophene), poly(3-hexylthiophene), poly(3-octylthiophene) and poly(3-decylthiophene); poly(3-alkoxythiophene) such as poly(3-methoxylthiophene), poly(3-ethoxylthiophene) and poly(3-dodecyloxyl)thiophene; and poly(3-alkoxy-4-alkylthiophene) such as poly(3-methoxy-4-methylthiophene) and poly(3-dodecyloxy-4-methylthiophene).

The 2,1,3-benzothiadiazole-thiophene copolymer refers to a conjugated copolymer having a thiophene skeleton and a 2,1,3-benzothiadiazole skeleton in a main chain. Specific examples of the 2,1,3-benzothiadiazole-thiophene copolymer include copolymers having the following structures. In the following formula, n indicates a number in a range of 1 to 1000.

[Chem. 5]

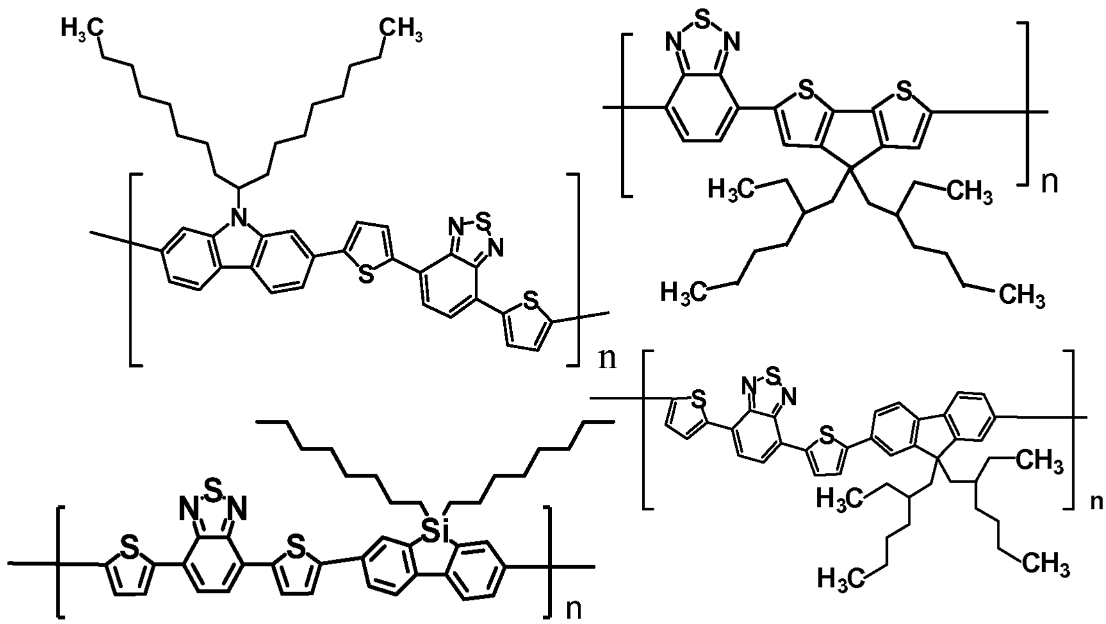

The quinoxaline-thiophene copolmer refers to a conjugated copolymer having a thiophene skeleton and a quinoxaline skeleton in a main chain. Specific examples of the quinoxaline-thiophene copolymer include copolymers having the following structures. In the following formula, n indicates a number in a range of 1 to 1000.

[Chem. 6]

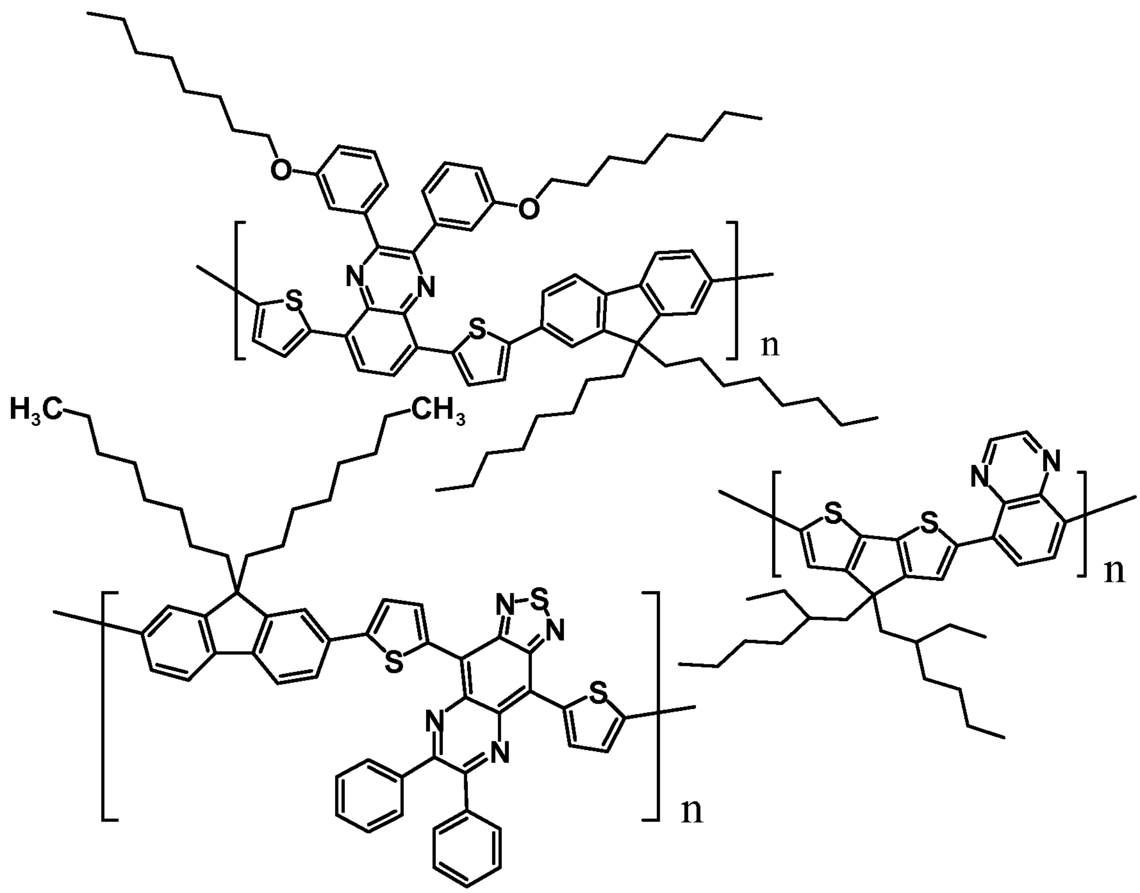

The thiophene-benzothiophene copolmer refers to a conjugated copolymer having a thiophene skeleton and a benzothiophene skeleton in a main chain. Specific examples of the thiophene-benzothiophene copolymer include copolymers having the following structures. In the following formula, n indicates a number in a range of 1 to 1000.

[Chem. 7]

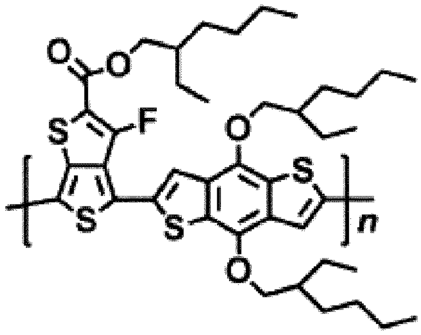

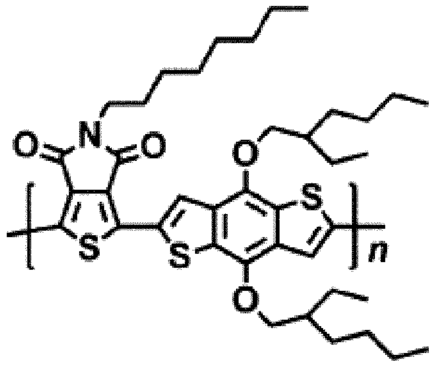

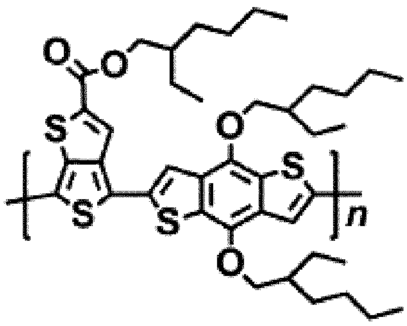

The poly(p-phenylenevinylene) polymer refers to a conjugated polymer having a polyphenylenevinylene skeleton in a main chain and also includes a conjugated polymer having a side chain. Specific examples thereof include poly[2-methoxy-5-(2-ethylhexyloxy)-1,4-phenylenevinylene], poly[2-methoxy-5-(3',7'-dimethyloctyloxy)-1,4-phenyleneviny lene] and the like.

(B) The electron accepting organic semiconductor is not particularly limited as long as it is an organic material exhibiting n-type semiconductor properties. Examples thereof include 1,4,5,8-naphthalene tetracarboxylic dianhydride, 3,4,9,10-perylenetetracarboxylic dianhydride, N,N'-dioctyl-3,4,9,10-naphthyltetracarboxy diimide, oxazole derivatives (2-(4-biphenyl)-5-(4-t-butylphenyl)-1,3,4-oxadiazole), 2,5-di(1-naphthyl)-1,3,4-oxadiazole, etc.), triazole derivatives (3-(4-bephenyl)-4-phenyl-5-(4-t-butylphenyl)-1,2,4-triazole, etc.), phenanthroline derivatives, fullerene derivatives, carbon nano-tubes, and a derivative (CN-PPV) prepared by introducing a cyano group to a poly(p-phenylenevinylene) polymer. Two or more kinds of these may be used. The fullerene derivatives are preferably used since they are n-type semiconductors which are stable and have high carrier mobility.

Specific examples of the fullerene derivatives include: unsubstituted fullerene derivatives including $C_{60}$, $C_{70}$, $C_{76}$, $C_{78}$, $C_{82}$, $C_{84}$, $C_{90}$ and $C_{94}$; and substituted fullerene derivatives including [6,6]-phenyl C61 butyric acid methylester ([6,6]-C61-PCBM, or [60]PCBM), [5,6]-phenyl C61 butyric acid methylester, [6,6]-phenyl C61 butyric acid hexylester, [6,6]-phenyl C61 butyric acid dodecylester, and phenyl C71 butyric acid methylester ([70]PCBM). Among these, [70]PCBMis more preferred.

The photovoltaic element of the present invention has an electron extraction layer containing a compound group represented by the general formula (1). The electron extraction layer is characterized in that it can not only realize electron extraction efficiency higher than a conventional electron extraction layer, but also adapt to wide range of film thicknesses since it does not have optical absorption in a visible region. The electron extraction layer may contain materials other than the compound group represented by the general formula (1) within a range which does not impair the effect of the present invention. Examples of the materials other than the compound group represented by the general formula (1) include electron transporting organic materials such as phenanthroline monomer compounds (BCP) heretofore used in a charge transporting layer or the like, and electron transporting inorganic materials, for example, oxides such as $TiO_2$, ZnO, $SiO_2$, $SnO_2$, $WO_3$, $Ta_2O_3$, $BaTiO_3$, $BaZrO_3$, $ZrO_2$, $HfO_2$, $Al_2O_3$, $Y_2O_3$ and $ZrSiO_4$, nitrides such as $Si_3N_4$, and semiconductors such as CdS, ZnSe and ZnS.

Additionally, the electron extraction layer may contain materials not having an electron transporting property within a range which does not significantly interfere with the electron extraction from the photoelectric conversion layer to the cathode in the photovoltaic element of the present invention. These materials other than the compound group represented by the general formula (1) may form a mixed layer with a compound group represented by the general formula (1), or may form a structure in which these materials are stacked on a layer of the compound group represented

by the general formula (1). When the mixed layer is formed, the content percentage of the compound group represented by the general formula (1) in the electron extraction layer is not particularly limited, and it is preferably 1 to 99 wt%, more preferably 10 to 99 wt%.

The film thickness of the electron extraction layer may be appropriately set to an optimum value according to the desired photoelectric conversion efficiency of the photovoltaic element; however, it is preferably 0.1 to 50 nm, more preferably 0.5 to 10 nm.

Moreover, as the photovoltaic element of the present invention, two or more photoelectric conversion layers may be stacked (into a tandem structure), with one or more charge recombination layers interposed therebetween, so that series junctions may be formed. For example, the stacked layer structure includes: substrate/anode/first photoelectric conversion layer /first electron extraction layer/charge recombination layer/second photoelectric conversion layer/second electron extraction layer/cathode. By using this stacked layer structure, it becomes possible to improve an open voltage. Additionally, the aforementioned hole extraction layer may be disposed between the anode and the first photoelectric conversion layer, as well as between the charge recombination layer and the second photoelectric conversion layer, or the hole extraction layer may be disposed between the first photoelectric conversion layer and the charge recombination layer, as well as between the second photoelectric conversion layer and the cathode. The charge recombination layer used herein needs to have a light-transmitting property so that a plurality of photoelectric conversion layers can perform optical absorption.

Moreover, since the charge recombination layer may be designed so as to adequately recombine the hole with the electron, it is not necessarily a film and may be, for example, a metal cluster which is uniformly formed on the photoelectric conversion layer. Accordingly, as the charge recombination layer, very thin metal films or metal clusters (including alloys) which are composed of the above-mentioned gold, platinum, chromium, nickel, lithium, magnesium, calcium, tin, silver or aluminum, and has a thickness of about several angstroms to several tens of angstroms and a light-transmitting property; films and clusters of metal oxide having a high light-transmitting property, such as ITO, IZO, AZO, GZO, FTO, titanium oxide and molybdenum oxide; films of conductive organic materials such as PEDOT to which PSS is added; or composite materials thereof are used.

For example, when silver is evaporated onto a quartz oscillator type film thickness monitor so as to be several angstroms to 1 nm in thickness by using a vacuum vapor deposition method, a uniform silver cluster can be formed. In addition to this, when a titanium oxide film is formed, a sol-gel method which is described in "Advanced Materials", pp. 572-576, Volume 18, 2006 may be used. When a composite metal oxide such as ITO or IZO is used, a film may be formed by using a sputtering method. A forming method or the kinds of these charge recombination layer may be appropriately selected in consideration of the non-destructivity against the photoelectric conversion layer in forming the charge recombination layer or the forming method of a next photoelectric conversion layer to be stacked.

Next, a method for producing a photovoltaic element of the present invention will be described. A transparent electrode (in this case, corresponding an anode) such as ITO is formed on a substrate by a sputtering method or the like. Then, materials for a photovoltaic element, including an electron donating organic semiconductor material and an electron accepting organic material, is dissolved in a solvent to prepare a solution, and the solution is applied onto the transparent electrode to form a photoelectric conversion layer. The solvent used at this time is preferably an organic solvent, and examples thereof include methanol, ethanol, butanol, toluene, xylene, o-chlorophenol, acetone, ethyl acetate, ethylene glycol, tetrahydrofurane, dichloromethane, chloroform, dichloroethane, chlorobenzene, dichlorobenzene, trichlorobenzene, chloronaphthalene, dimethylformamide, dimethylsulfoxide, N-methylpyrrolidone, and $\gamma$-butyrolactone. Two or more kinds of these may be used. Moreover, by adding an appropriate additive to the solvent, it is possible to change a phase-separation structure between the electron donating organic semiconductor material and the electron accepting organic material in the photoelectric conversion layer. Examples of an additive include thiol compounds such as 1, 8-octanediol, and iodine compounds such as 1,8-diiodooctane.

When the electron donating organic material and the electron accepting organic material of the present invention are mixed so as to form a photoelectric conversion layer, the electron donating organic material and the electron accepting organic material of the present invention are added to a solvent at the desired ratio, and by dissolving these by using a method such as, heating, stirring, or irradiating with ultrasonic wave, the resulting solution is applied onto the transparent electrode. Moreover, in the case where the electron donating organic material and the electron accepting organic material of the present invention are stacked so as to form a photoelectric conversion layer, for example, after the solution of the electron donating organic material of the present invention is applied to form a layer having the electron donating organic material thereon, a solution of the electron accepting organic material is applied thereto so that a layer is formed. Here, when each of the electron donating organic material and the electron accepting organic material of the present invention is a low-molecular-weight substance whose molecular weight is about 1000 or less, the layer may be formed by using a vapor deposition method.

The photoelectric conversion layer may be formed by using any of the following application methods : a spin coating method, a blade coating method, a slit die coating method, a screen printing method, a bar coating method, a mold coating method, a print transfer method, a dip coating method, an ink-jet method, a spraying method, a vacuum

vapor deposition method, and the like, and the formation method may be properly selected depending on the characteristics of a photoelectric conversion layer to be obtained, such as film-thickness controlling and orientation controlling. For example, in the case of carrying out the spin coating method, the electron donating organic material and the electron accepting organic material of the present invention preferably have a concentration of 1 to 20 g/l (a weight of the electron donating organic material and the electron accepting organic material of the present invention relative to a volume of a solution containing the electron donating organic material and the electron accepting organic material of the present invention and a solvent), and when this concentration is employed, a uniform photoelectric conversion layer with a thickness in a range from 5 to 200 nm can be obtained. In order to remove the solvent, the obtained photoelectric conversion layer may be subjected to an annealing treatment under reduced pressure or in an inert atmosphere (in a nitrogen or argon atmosphere). The temperature of the annealing treatment is preferably set in a range from 40°C to 300°C, more preferably, from 50°C to 200°C. This annealing treatment may be carried out after the formation of the cathode.

Then, materials for the electron extraction layer, including a compound represented by the general formula (1), is dissolved in a solvent to prepare a solution, and an electron extraction layer is formed on the photoelectric conversion layer. The solvent used at this time is preferably an organic solvent, and examples thereof include methanol, ethanol, butanol, toluene, xylene, o-chlorophenol, acetone, ethyl acetate, ethylene glycol, tetrahydrofurane, dichloromethane, chloroform, dichloroethane, chlorobenzene, dichlorobenzene, trichlorobenzene, chloronaphthalene, dimethylformamide, dimethylsulfoxide, N-methylpyrrolidone, and γ-butyrolactone. Two or more kinds of these may be used.

The electron extraction layer may be formed by using the same application method as in the preparation of the photoelectric conversion layer, and the formation method may be properly selected depending on an electron extraction layer to be obtained, such as film-thickness controlling and orientation controlling. For example, in the case of carrying out the spin coating method, the compound of the present invention, represented by the general formula (1), preferably has a concentration of 0.01 to 5 g/l, and when this concentration is employed, an electron extraction layer with a thickness of about 0.1 to 40 nm can be obtained. In order to remove the solvent, the obtained electron extraction layer may be subjected to an annealing treatment under reduced pressure or in an inert atmosphere (in a nitrogen or argon atmosphere). The temperature of the annealing treatment is preferably set in a range from 40°C to 300°C, more preferably, from 50°C to 200°C. This annealing treatment may be carried out after the formation of the cathode.

An electrode (in this case, corresponding a cathode) of metal such as Ag is formed on the electron extraction layer by a vacuum vapor deposition method, a sputtering method or the like. When the electron extraction layer is formed by a vacuum vapor deposition method, subsequently the metal electrode is preferably formed by a vacuum deposition while maintaining vacuum.

When a hole extraction layer is disposed between the anode and the photoelectric conversion layer, after a desired p-type organic semiconductor material (PEDOT or the like) is applied on the anode by a spin coating method, a bar coating method, or a casting method by the use of a blade, the solvent is removed by using a vacuum thermostat, a hot plate or the like so that the hole extraction layer is formed. When inorganic materials such as molybdenum oxide or the like are used, a vacuum vapor deposition method by the use of a vacuum vapor deposition machine may be adopted.

The photovoltaic element of the present invention can be applicable to various photoelectric conversion devices in which its photoelectric conversion function, photo-rectifying function, or the like is utilized. For example, it is useful for photoelectric cells (solar cells, etc.), electron elements (such as a photosensor, photoswitch, phototransistor, etc.) and photorecording materials (photomemory, etc.).

EXAMPLES

Hereinafter, the present invention will be described in more detail based on examples. In addition, the present invention is not intended to be limited by the following examples. Also, among compounds which are used in the examples, those indicated by abbreviations are shown below.

Isc: Short-circuit current density
Voc: Open circuit voltage
η: Photoelectric conversion efficiency
ITO: Indium tin oxide
PEDOT: Polyethylene dioxythiophene
PSS: Polystyrene sulfonate
A-1: Compound represented by the following formula

(manufactured by 1-Material Inc.)

[Chem. 8]

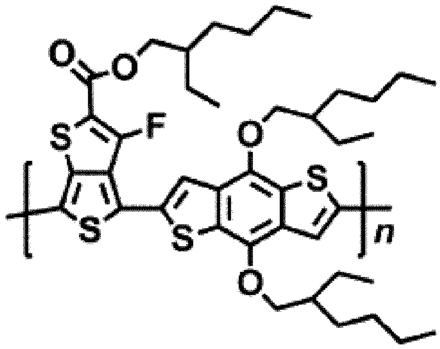

(A-1)

[70]PCBM: Phenyl C71 butyric acid methyl ester
CF: Chloroform
IPA: 2-propanol
BCP: 2,9-dimethyl-4,7-diphenyl-1,10-phenanthroline

(bathocuproine)

The photoelectric conversion efficiency in each example/comparative example was determined based on the following expression:

$$\eta(\%) = Isc\ (mA/cm^2) \times Voc\ (V) \times FF/\text{Intensity of irradiation light}\ (mW/cm^2) \times 100$$

$$FF = JVmax/(Isc(mA/cm^2) \times Voc(V))$$

wherein JVmax ($mW/cm^2$) corresponds to a value of product of the electric current density and the applied voltage at a point where the product of the electric current density and the applied voltage becomes the largest between 0 V of the applied voltage and the open circuit voltage value.

A deterioration rate of the photoelectric conversion efficiency in each example/comparative example was determined based on the following expression:

Deterioration rate (%) = Photoelectric conversion efficiency after continuous light irradiation (%)/Photoelectric conversion efficiency immediately after start of light irradiation (%) × 100.

Example 1

A CF solvent (0.10 ml) was added to a sample bottle containing 0.4 mg of the A-1 and 0.6 mg of [70] PCBM (manufactured by Solenn Co., Ltd.), and this was irradiated with ultrasonic waves for 30 minutes in a ultrasonic cleaning machine (US-2 manufactured by Iuchi Seieido Co., Ltd., output: 120 W) to obtain a solution A.

A glass substrate on which an ITO transparent conductive layer serving as an anode was deposited by a sputtering method with a thickness of 125 nm was cut into a size of 38 mm x 46 mm, and the ITO layer was then patterned into a rectangular shape of 38 mm x 13 mm by a photolithography method. Light transmittance of the resulting substrate was measured with a spectrophotometer U-3010 manufactured by Hitachi, Ltd., and consequently it was 85% or more

in all wavelength region of 400 nm to 900 nm. The substrate was cleaned with ultrasonic waves for 10 minutes in an alkali cleaning solution ("Semicoclean" EL56, manufactured by Furuuchi Chemical Corporation), and then washed with ultrapure water. After this substrate was subjected to a UV/ozone treatment for 30 minutes, an aqueous PEDOT : PSS solution (PEDOT 0.8% by weight, PPS 0.5% by weight) was applied onto the substrate by a spin coating method and heated to dry at 200°C for five minutes by using a hot plate to form a film with a thickness of 60 nm. The above-mentioned solution A was added dropwise to the PEDOT : PSS layer and formed into a photoelectric conversion layer having a thickness of 100 nm by spin coating method. Thereafter, a 0.5 g/l ethanol solution of sodium myristate (sodium tetradecanoate) (manufactured by Tokyo Chemical Industry Co., Ltd.) was added dropwise to the photoelectric conversion layer and formed into a film by a spin coating method (thickness about 5 nm). Thereafter, the substrate and a mask for a cathode were placed in a vacuum vapor deposition apparatus, and the apparatus was evacuated until the degree of vacuum inside the apparatus reached $1 \times 10^{-3}$ Pa or less so that an aluminum layer serving as a cathode was vapor-deposited with a thickness of 100 nm by a resistive heating method. Extraction electrodes were drawn from upper and lower electrodes of the prepared element to prepare a photovoltaic element in which an area of a portion where a band-like ITO layer and a silver layer overlap one another is 5 mm x 5 mm.

The upper and lower electrodes of the photovoltaic element thus produced were connected to 2400 series SourceMeter manufactured by Keithley Instruments, Inc., and the element was irradiated with white light (AM 1.5, Intensity: 100 mW/cm$^2$) from the ITO layer side in the atmosphere; thus, the electric current value was measured, with the applied voltage being varied from -1 V to +2 V. Measurement was performed immediately after light irradiation. The photoelectric conversion efficiency (η) calculated based on these values was 4.90%.

Example 2

A photovoltaic element was prepared in the same manner as in Example 1 except for using 1-hexadecanesulfonic acid sodium salt (manufactured by Tokyo Chemical Industry Co., Ltd.) in place of sodium myristate, and the photoelectric conversion efficiency (η) was calculated, and consequently, it was 4.60%.

Example 3

A photovoltaic element was prepared in the same manner as in Example 1 except for using a 0.2 g/l IPA solution of sodium dodecyl sulfate (manufactured by Tokyo Chemical Industry Co., Ltd.) in place of 0.5 g/l ethanol solution of sodium myristate, and the photoelectric conversion efficiency (η) was calculated, and consequently, it was 4.06%.

Example 4

A photovoltaic element was prepared in the same manner as in Example 1 except for using a 0.2 g/l methanol solution of sodium monododecyl phosphate (manufactured by Tokyo Chemical Industry Co., Ltd.) in place of 0.5 g/l ethanol solution of sodium myristate, and the photoelectric conversion efficiency (η) was calculated, and consequently, it was 4.39%.

Example 5

A photovoltaic element was prepared in the same manner as in Example 1 except for using a 0.1 g/l ethanol solution of sodium cholate (manufactured by Tokyo Chemical Industry Co., Ltd.) in place of 0.5 g/l ethanol solution of sodium myristate, and the photoelectric conversion efficiency (η) was calculated, and consequently, it was 4.82%.

Comparative Example 1

A photovoltaic element was prepared in the same manner as in Example 1 except for not disposing the electron extraction layer, and the photoelectric conversion efficiency was calculated, and consequently, it was 3.59%.

Comparative Example 2

A photovoltaic element was prepared in the same manner as in Example 1 except for using a 0.1 g/l methanol solution of sodium benzoate (manufactured by Tokyo Chemical Industry Co., Ltd.) in place of 0.5 g/l ethanol solution of sodium myristate, and the photoelectric conversion efficiency (η) was calculated, and consequently, it was 4.07%.

[Table 1]

| | Electron Extraction Layer | Solvent | Concentration | Photoelectric conversion efficiency |
|---|---|---|---|---|
| Example 1 | sodium myristate | ethanol | 0.5 g/l | 4.90% |
| Example 2 | 1-hexadecanesulfonic acid sodium salt | ethanol | 0.5 g/l | 4.60% |
| Example 3 | sodium dodecyl sulfate | IPA | 0.2 g/l | 4.06% |
| Example 4 | sodium monododecyl phosphate | methanol | 0.2 g/l | 4.39% |
| Example 5 | sodium cholate | ethanol | 0.1 g/l | 4.82% |
| Comparative Example 1 | none | - | - | 3.59% |
| Comparative Example 2 | sodium benzoate | methanol | 0.1 g/l | 4.07% |

The results of Examples and Comparative Examples are summarized in Table 1. It is found from the contrast between Examples 1 to 5 and Comparative Example 1 and the contrast between Examples 1, 5 and Comparative Example 2 that the photoelectric conversion efficiency of the photovoltaic element can be improved in accordance with the present invention.

DESCRIPTION OF REFERENCE SIGNS

1: Substrate
2: Anode
3: Photoelectric conversion layer
4: Electron extraction layer
5: Cathode

## Claims

1. A photovoltaic element comprising at least an anode, a photoelectric conversion layer, an electron extraction layer and a cathode in this order, wherein the electron extraction layer contains a compound represented by the following general formula (1) :
[Chem. 1]

$$R — X^{-} M^{+} \qquad (1)$$

wherein R is selected from among hydrogen, and alkyl group which may have a substituent, $X^-$ is selected from among $-COO^-$, $-SO_3^-$, $-PO_4H^-$, $-PO_4^{2-}$, $-O-SO_3^-$, and M is selected from among alkali metals, alkaline-earth metals, and ammonium ion.

2. The photovoltaic element according to claim 1, wherein X is -COO-.

3. The photovoltaic element according to claim 1 or 2, wherein M is Na.

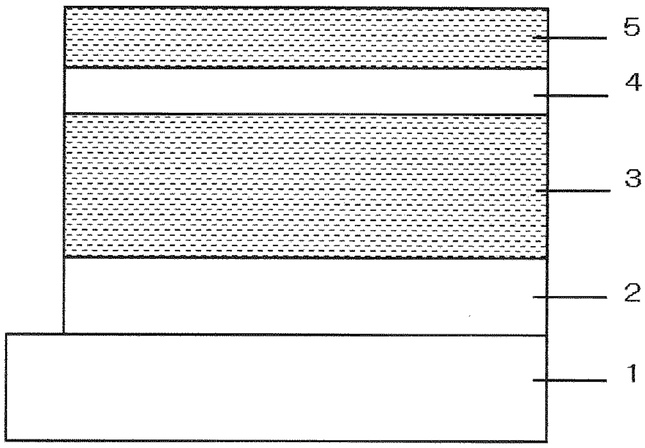


Figure 1

## INTERNATIONAL SEARCH REPORT

International application No.
PCT/JP2013/064604

A. CLASSIFICATION OF SUBJECT MATTER
*H01L51/42*(2006.01)i, *H01L31/10*(2006.01)i

According to International Patent Classification (IPC) or to both national classification and IPC

B. FIELDS SEARCHED

Minimum documentation searched (classification system followed by classification symbols)
H01L51/42, H01L31/10

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2013 |
| Kokai Jitsuyo Shinan Koho | 1971-2013 | Toroku Jitsuyo Shinan Koho | 1994-2013 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| A | JP 2012-39097 A (Toray Industries, Inc.), 23 February 2012 (23.02.2012), entire text; all drawings (Family: none) | 1-3 |
| A | JP 2012-64645 A (Mitsubishi Chemical Corp.), 29 March 2012 (29.03.2012), paragraphs [0041] to [0044]; fig. 1 (Family: none) | 1-3 |
| A | JP 2012-23407 A (Dainippon Printing Co., Ltd.), 02 February 2012 (02.02.2012), paragraphs [0092] to [0093]; fig. 5 (Family: none) | 1-3 |

☐ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 07 June, 2013 (07.06.13) | 18 June, 2013 (18.06.13) |

| Name and mailing address of the ISA/ | Authorized officer |
|---|---|
| Japanese Patent Office | |
| Facsimile No. | Telephone No. |

Form PCT/ISA/210 (second sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2005353401 A

### Non-patent literature cited in the description

- *Advanced Materials,* 2011, vol. 23, 4636-4643
- *Advanced Functional Materials,* 2011, vol. 21, 4338-4341
- *Advanced Materials,* 2006, vol. 18, 572-576